# EUROPÄISCHE PATENTANMELDUNG

(11) **EP 2 221 785 A1**
(43) Veröffentlichungstag der Anmeldung: **25.08.2010**
(21) Anmeldenummer: 10000791.3
(22) Anmeldetag: 27.01.2010
(51) Int. Cl.: G08B 13/14, G01R 31/26, H01L 31/042

(54) **Alarmsystem für Photovoltaikmodule sowie Verfahren zum Schutz einer Photovoltaikanlage vor Diebstahl**

(30) Priorität: 30.01.2009 DE 102009006999
(71) Anmelder: SCHOTT Solar AG, 55122 Mainz (DE)
(72) Erfinder: Thiemann, Christian, 55126 Mainz (DE)
(74) Vertreter: Herden, Andreas F.

(57) **Zusammenfassung**

Die Erfindung betrifft ein Alarmsystem für Photovoltaikmodule, bei welcher eine Alarmanlage elektrisch mit zumindest einem Photovoltaikmodul verbunden ist.

## Beschreibung

### Gebiet der Erfindung

Die Erfindung betrifft ein Alarmsystem für Photovoltaikmodule sowie ein Verfahren zum Schutz einer Photovoltaikanlage vor Diebstahl.

### Hintergrund der Erfindung

Photovoltaikanlagen mit Solarzellen sind bekannt. Es handelt sich dabei in der Regel um Anlagen, welche aus Modulen aufgebaut sind. Die Solarzellen enthaltenden Module werden in der Regel mit einem Netzeinspeisegerät verbunden, über das der von den Solarzellen erzeugte Strom, umgewandelt in eine Wechselspannung geeigneter Höhe, in das Stromnetz eingespeist werden kann. Derartige Anlagen haben vor allem aufgrund staatlicher Förderungen bereits in den letzten Jahren einen hohen Verbreitungsgrad erreicht und sind nicht nur auf Dächern von Wohnhäusern und Bürogebäuden, sondern vermehrt auch an abgelegenen Orten wie im Außenbereich zu finden.

Die Erstellung einer Photovoltaikanlage ist mit hohen Investitionskosten verbunden, insbesondere sind die hochwertigen Photovoltaikmodule ein hoher Kostenfaktor.

Es kommt daher vermehrt zu Diebstählen von Photovoltaikmodulen. Auf dem Markt erhältlich sind zwar Montagemittel, welche den Diebstahl von Solarmodulen erschweren. Insbesondere ist es bekannt, Schrauben zu verwenden, bei denen beispielsweise ein Teil des Kopfes nach dem Einschrauben abbricht, so dass die Schraube mit gewöhnlichem Werkzeug nicht mehr zu entfernen ist. Derartige Diebstahlschutzmittel führen aber nur zu einer Erschwerung des Diebstahls, was insbesondere im Außenbereich oft keine große Rolle spielt, da die Diebe genug Zeit zur Verfügung haben.

Weiter ist es bekannt, Solarmodule mit Seriennummern zu versehen, um gestohlene Solarmodule wiedererkennen zu können. Eine derartige Sicherung hat allenfalls einen begrenzten Abschreckungseffekt.

Aus der Sicherheitstechnik bekannte Alarmanlagen sind nur mit zumeist hohem Aufwand in eine Photovoltaikanlage zu implementieren. Bekannte drahtgebundene Alarmanlagen würden einen Schalter an jedem einzelnen Solarmodul erfordern. Eine drahtlose Überwachung, etwa über einen Transponder, ist generell sehr aufwändig.

Das Dokument DE 20 2007 011 806 U1 zeigt eine Alarmanlage für Photovoltaikmodule, bei welcher Speicherbausteine, die einen Identifizierungscode tragen, über einen Bus mit der Alarmanlage verbunden sind. Hierzu sind in die Photovoltaikmodule eingesetzte Speierbausteine erforderlich, in denen ein individueller Identifizierungscode hinterlegt ist. Das System ist somit aufwändig und lässt sich nicht oder nur mit sehr hohem Aufwand nachträglich in eine bestehe Photovoltaikanlage implementieren.

### Aufgabe der Erfindung

Der Erfindung liegt demgegenüber die Aufgabe zugrunde, ein Alarmsystem für Photovoltaikmodule zu schaffen, welches zuverlässig, einfach und preiswert ausgebildet sein kann.

Es ist insbesondere eine Aufgabe der Erfindung, ohnehin bestehende Bauelemente einer Photovoltaikanlage in ein Alarmsystem einzubinden.

Eine weitere Aufgabe der Erfindung ist es, ein Alarmsystem bereitzustellen, welches sich in besonders einfacher Weise bei bereits installierten Photovoltaikanlagen nachrüsten lässt.

### Zusammenfassung der Erfindung

Die Aufgabe der Erfindung wird bereits durch ein Alarmsystem für Photovoltaikmodule sowie durch ein Verfahren zum Schutz einer Photovoltaikanlage vor Diebstahl nach einem der unabhängigen Ansprüche gelöst.

Bevorzugte Ausführungsformen und Weiterbildungen der Erfindung sind den jeweiligen Unteransprüchen zu entnehmen.

Die Erfindung betrifft zum einen ein Alarmsystem für Photovoltaikmodule, bei welchem eine Alarmanlage mit zumindest einem Photovoltaikmodul elektrisch verbunden ist.

Über eine elektrische Verbindung über eine ohnehin vorhandene Stromanschlussleitung, ist eine besonders einfache Überwachung der Photovoltaikmodule möglich.

Beispielsweise im Falle der Unterbrechung des Stromkreises kann über die Alarmanlage ein Alarmsignal generiert werden.

Die Generierung von Alarmsignalen ist bekannt. Im Sinne der Erfindung kann beispielsweise eine Alarmsirene angeschaltet werden und/oder der Alarm beispielsweise an ein Überwachungsunternehmen weitergeleitet werden. Für im Außenbereich installierte Alarmanlagen kann zur Weiterleitung des Alarmsignals auch auf drahtlose Technologien wie GSM oder UTMS zurückgegriffen werden.

Gemäß der Erfindung wird als Kennung die Impulsantwort eines Photovoltaikmoduls oder einer Gruppe von Photovoltaikmodulen verwendet.

Zumeist sind in den Photovoltaikmodulen ohnehin schon aktive und/oder passive Bauelemente vorhanden.

Insbesondere wird durch vorhandene Dioden, Bypassdioden, Solarzellen und/oder Transistoren eine charakteristische Impulsantwort erzeugt.

Die Ausnutzung dieser ohnehin vorhandenen Bauelemente, welche zur Verteilung und/oder Umwandlung des von den Photovoltaikmodulen erzeugten Stroms vorgesehen sind, ermöglicht es, ein Alarmsystem bereit zu stellen, welches nachträglich in eine bestehende Photovoltaikanlage eingebaut werden kann, ohne dass an den Photovoltaikmodulen selbst Veränderungen vorgenommen werden müssen.

So kann das Alarmsystem beispielsweise an den Leitungen eines Netzeinspeisegerätes angeschlossen werden. In einem Programmiermodus wird die Impulsantwort der Photovoltaikanlage ausgelesen und in einem Speicher hinterlegt. Im scharf gestellen Modus überprüft das Alarmsystem regelmäßig die Impulsantwort der Photovoltaikanlage, die auf einer Mehrzahl an Modulen basiert Wird nun ein einziges Photovoltaikmodul entfernt, ändert sich die Impulsantwort der gesamten Anlagen, was von dem Alarmsystem erkannt wird und es wird ein Alarm ausgelöst.

Passive Bauelemente wie Induktivitäten und Kondensatoren ermöglichen eine einfache Änderung oder Verstärkung der Impulsantwort. So kann bei einer Ausführungsform der Erfindung eine Mehrzahl von Kennungen durch den Einbau verschiedener passiver Bauelemente in verschiedenen Photovoltaikmodulen erreicht werden. Auch können bei neu herstellten Photovoltaikmodulen zusätzliche elektrische Bauelemente vorgesehen sein, die keine Funktion bei Erzeugung oder Verteilung des erzeugten Stroms haben, sondern die die Impulsantwort verstärken und so zu einer besseren Auslesbarkeit der Impulsantwort beitragen.

Die Impulsantwort kann beispielsweise über ein in die Stromanschlussleitung eingespeistes Signal ausgelesen werden.

Die elektrischen oder elektronischen Bauelemente im Photovoltaikmodul sind vorzugsweise einlaminiert, was dazu führt, dass ein Ausbau zur Zerstörung des Photovoltaikmoduls führen würde. Es ist somit für einen Dieb nicht möglich, die elektrischen Bauelemente, durch welche letztendlich die Kennung definiert wird, auszubauen und damit den Anschluss des Solarmoduls zu überbrücken.

Insbesondere ist dies nicht möglich, da die Impulsantwort auch durch Bauelemente, welche für den Betrieb des Photovoltaikmoduls notwendig sind, charakterisiert ist.

Bei einer bevorzugten Ausführungsform der Erfindung ist die Alarmanlage in einem Netzeinspeisegerät integriert. So ist eine besonders einfache Implementierung der Alarmanlage in der Photovoltaikanlage möglich.

Das Alarmsystem umfasst vorzugsweise eine Mehrzahl von Photovoltaikmodulen beziehungsweise eine Mehrzahl von Photovoltaikmodulgruppen, welche mit einer für die Alarmanlage auslesbaren Kennung versehen sind. Insbesondere beim Auslesen der Impulsantwort können die Photovoltaikmodule im Sinne der Erfindung also auch als Gruppen zusammengefasst werden, wodurch sich beispielsweise beim Auslesen eines Photovoltaikmoduls die Impulsantwort der Photovoltaikmodulgruppe, zu welcher das Photovoltaikmodul gehört, ändert.

Bei einer bevorzugten Ausführungsform der Erfindung umfasst die Alarmanlage einen Speicher, in welchem eine Mehrzahl von Photovoltaikmodulen beziehungsweise Photovoltaikmodulgruppen Kennungen abspeicherbar sein.

Die Erfindung betrifft des Weiteren ein Verfahren zum Schutz einer Photovoltaikanlage vor Diebstahl.

Dabei wird eine Kennung, die zumindest einem Photovoltaikmodul oder einer Photovoltaikmodulgruppe zugeordnet ist, wiederholt ausgelesen. Unter einem wiederholten Auslesen wird ein regelmäßiges oder unregelmäßiges Auslesen verstanden, so dass zumindest zeitweise eine kontinuierliche Überwachung der Photovoltaikmodule sichergestellt ist. Die Zeitabstände zwischen dem Auslesen sind also kurz, dass es für einen Dieb nicht möglich ist, in einer Auslesepause ein Modul zu demontieren und fortzuschaffen.

Falls eine Kennung nicht auslesbar ist beziehungsweise sich verändert hat, wird von der Alarmanlage in bekannter Weise ein Alarmsignal generiert.

Als Kennung wird eine Impulsantwort ausgelesen. Bei einer Ausführungsform der Erfindung wird das Alarmsystem in eine bereits bestehende Photovoltaikanlage nachträglich implementiert.

Die für das Verfahren verwendete Alarmanlage wird bei einer bevorzugten Ausführungsform des Verfahrens in einen Programmiermodus versetzt, in welchen sie automatisch die Kennung zumindest eines Photovoltaikmoduls speichert.

### Kurzbeschreibung der Zeichnungen

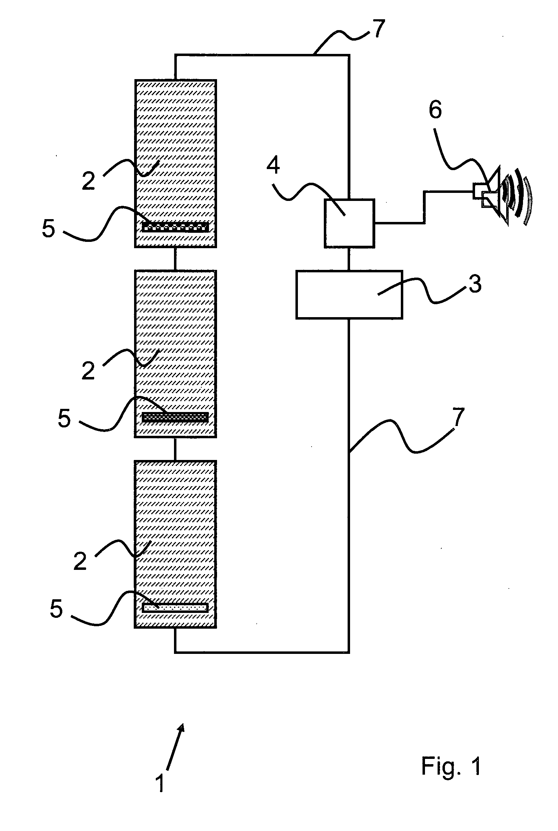

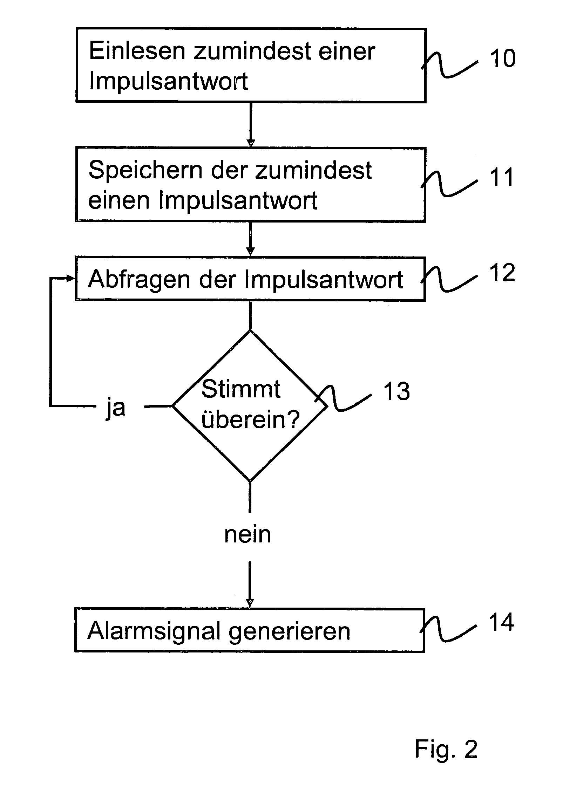

Die Erfindung soll im Folgenden bezugnehmend auf die Zeichnungen Fig. 1 und Fig. 2 näher erläutert werden.
- Fig. 1: zeigt schematisch ein Alarmsystem für eine Photovoltaikanlage,
- Fig. 2: zeigt ein schematisches Blockschaltbild eines Verfahrens zum Schutz einer Photovoltaikanlage vor Diebstahl.
- Fig.3 bis Fig. 5: zeigen verschiedene Beispiele von Impulsantworten

### Detaillierte Beschreibung der Zeichnungen

Bezugnehmend auf Fig. 1 soll schematisch ein Ausführungsbeispiel eines Alarmsystems 1 für Photovoltaikmodule 2 näher erläutert werden.

In diesem Ausführungsbeispiel ist schematisch eine Reihe von drei Photovoltaikmodulen 2 dargestellt, welche elektrisch in Reihe geschaltet sind und über die Stromanschlussleitungen 7 mit einem Netzeinspeisegerät 3 verbunden sind. Über das Netzeinspeisegerät 3 wird in bekannter Weise der von den Photovoltaikmodulen 2 erzeugte Strom umgewandelt und ins Netz (nicht dargestellt) eingespeist.

Das Alarmsystem 1 umfasst des Weiteren eine Alarmanlage 4, welche in diesem Ausführungsbeispiel mit einer Sirene 6 zur Generierung eines Alarms verbunden ist.

Im einfachsten Falle könnte von der Alarmanlage 4 ein Kontrollstromkreis aufrecht erhalten werden, bei deren Unterbrechung ein Alarm generiert wird.

In diesem Ausführungsbeispiel ist die Alarmanlage 4 aber ebenfalls über die Stromanschlussleitungen 7 mit den Photovoltaikmodulen 2 verbunden.

Um eine Überwachung zu gewährleisten, verfügt jedes Photovoltaikmodul 2 über ein elektrisches, insbesondere elektronisches Bauelement 5, welches eine individuelle Kennung aufweist. Die individuelle Kennung kann auch durch ein elektronisches Bauelement in Form eines integrierten Schaltkreises bereitgestellt sein.

Vorzugsweise werden aber zumindest auch passive und/oder aktive Bauelemente verwendet, welche gleichzeitig für die Funktion des Photovoltaikmoduls 2 vorgesehen sind, wie zum Beispiel Dioden, Bypassdioden oder die Solarzelle selbst.

Über die Alarmanlage 4 wird ein wiederkehrendes Signal generiert, welches in die Stromanschlussleitungen 7 eingespeist wird und dessen Impulsantwort von der Alarmanlage 4 ausgelesen wird.

Sobald eines der Solarmodule 2 entfernt wird, ändert sich, auch wenn der Dieb das fehlende Photovoltaikmodul überbrückt, die Impulsantwort der in Reihe geschalteten Photovoltaikmodule 5.

Dies wird von der Alarmanlage 4, in welcher das Referenzsignal, also die Impulsantwort mit allen Photovoltaikmodulen 2 gespeichert ist, erkannt und sodann ein Alarmsignal generiert, welches zumindest die Sirene 6 auslöst.

In diesem Ausführungsbeispiel sind nur drei in Reihe geschaltete Photovoltaikmodule 5 dargestellt. Es versteht sich, dass eine Photovoltaikanlage in der Regel über mehrere Gruppen von in Reihe geschalteten Photovoltaikmodulen verfügt.

Bezugnehmend auf Fig. 2 sollen die wesentlichen Schritte eines Ausführungsbeispiels eines Verfahrens zum Schutz einer Photovoltaikanlage vor Diebstahl näher erläutert werden.

Gemäß dieses Verfahrens wird zumindest eine Impulsantwort eines Photovoltaikmoduls oder einer Gruppe von Photovoltaikmodulen eingelesen 10.

Die eingelesene Impulsantwort wird von der Alarmanlage gespeichert 11. Dies erfolgt vorzugsweise in einem Programmiermodus.

Im Betrieb wird die gespeicherte Impulsantwort wiederholt abgefragt 12. Dazu generiert beispielsweise die Alarmanlage ein elektrisches Signal, dessen Impuls empfangen wird.

Stimmt die abgefragte Impulsantwort mit der gespeicherten Impulsantwort überein 13, wird die Impulsantwort nach einer mehr oder weniger kurzen Pause wieder abgefragt 12.

Sofern die Impulsantwort nicht mit der gespeicherten übereinstimmt, kann daraus geschlossen werden, dass sich an der Anordnung an Photovoltaikmodulen etwas verändert hat. Daraus kann erkannt werden, dass beispielsweise ein Photovoltaikmodul entfernt wurde und es wird ein Alarmsignal generiert 14.

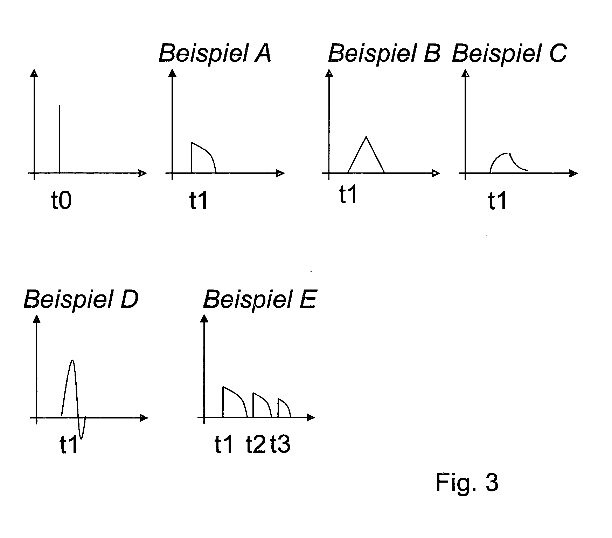

Bezugnehmend auf Fig. 3 sollen die Impulsantworten verschiedener elektronischer Schaltungen illustriert werden. Zu einem Zeitpunkt t₀ wird ein Impulssignal an das Solarmodular oder eine Gruppe von Solarmodulen gesandt. Zum Zeitpunkt t₁ (Beispiele A bis D) kann eine Impulsantwort gemessen werden. Die Beispiele A bis D zeigen verschiedene Impulsantworten, welche anhand eines charakteristischen Signals unterscheidbar sind.

Beispiel E zeigt eine periodische Wiederkehr einer Impulsantwort. In der Art eines Echos erfolgt eine charakteristische Impulsantwort zu den dargestellten Zeitpunkten t₁, t₂ und t₃.

Eine derartige periodische Impulsantwort eignet sich insbesondere zum Auseinanderhalten einer größeren Anzahl an Solarmodulen, bei welcher jedem Solarmodul eine charakteristische Impulsantwort zugeordnet is.

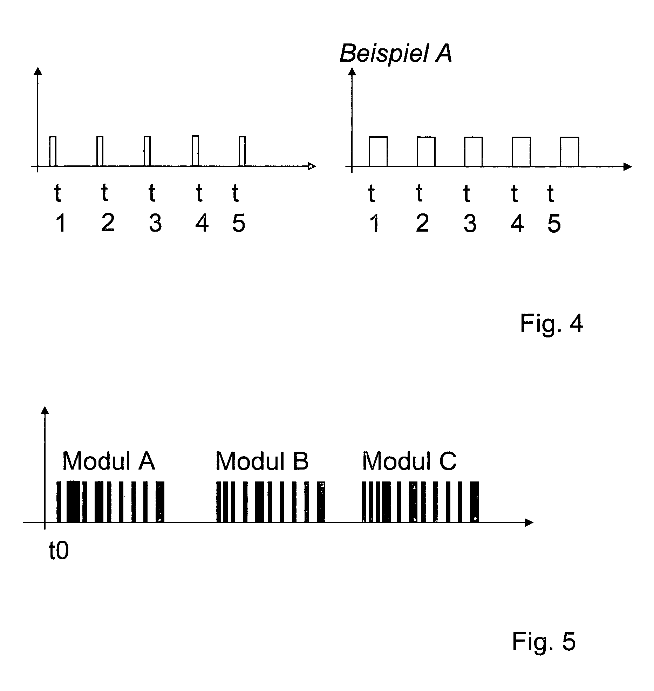

Bezugnehmend auf Fig. 4 soll ein weiteres Beispiel einer einfachen Diebstahlsicherung für ein Solarmodul erläutert werden.

Im Graphen rechts ist ein regelmäßiges Sendesignal dargestellt, das periodisch zu den Zeiten t₁ bis t₅ ausgesandt wird.
Im Graphen links ist die regelmäßige Impulsantwort, welche hier in Form eines Rechteckssignals erfolgt, aufgetragen. So ist eine kontinuierliche Diebstahlsicherung möglich. Wird ein Solarmodul entfernt, kann anhand des fehlenden Rechtecksignals darauf geschlossen und ein Alarm ausgelöst werden.

Bezugnehmend auf Fig. 5 wird eine alternative Ausführungsformen der Erfindung dargestellt, bei denen den Modulen zusätzlich ein individueller digitaler Code zugeordnet ist. Hierfür besitzen die Module einen elektronischen Schaltkreis, welcher als Antwort auf ein Sendesignal (nicht dargestellt) einen charakteristischen Digitalcode aussendet, anhand dessen jedes angeschlossene Modul identifiziert werden kann.

Die Erfindung ermöglicht eine besonders einfache und zuverlässige Implementierung eines Alarmsystems in einer Photovoltaikanlage.

Es versteht sich, dass der Gegenstand der Erfindung nicht auf eine Kombination vorstehend beschriebener Merkmale beschränkt ist, sondern dass der Fachmann sämtliche Merkmale, soweit dies sinnvoll ist, kombinieren wird.

### Bezugszeichenliste

- 1: Alarmsystem
- 2: Solarmodul
- 3: Netzeinspeisegerät
- 4: Alarmanlage
- 5: elektrisches Bauelement
- 6: Sirene
- 7: Stromanschlussleitung
- 10: Einlesen einer Impulsantwort
- 11: Speichern einer Impulsantwort
- 12: Abfragen einer Impulsantwort
- 13: Übereinstimmung prüfen
- 14: Alarmsignal generieren

## Patentansprüche

1. Alarmsystem für Photovoltaikmodule, umfassend eine mit zumindest einem Photovoltaikmodul elektrisch verbundene Alarmanlage, wobei die Alarmanlage über eine Stromanschlussleitung mit dem zumindest einen Photovoltaikmodul verbunden ist und wobei die Alarmanlage Mittel aufweist, um eine Impulsantwort des zumindest einen Photovoltaikmoduls auszulesen.

2. Alarmsystem nach dem vorstehenden Anspruch, **dadurch gekennzeichnet, dass** die Alarmanlage Mittel aufweist, um eine gespeicherte Impulsantwort mit einer ausgelesenen Impulsantwort zu vergleichen, wobei bei Abweichung der gespeicherten Impulsantwort von der ausgelesenen Impulsantwort ein Alarm generierbar ist.

3. Alarmsystem nach einem der vorstehenden Ansprüche, **dadurch gekennzeichnet, dass** die ausgelesene Impulsantwort zumindest teilweise auf einem elektrischen oder elektronischen Bauelement basiert, welches für die Stromerzeugung und/oder Verteilung als funktionelles Bauelement vorgesehen ist.

4. Alarmsystem für Photovoltaikmodule nach einem der vorstehenden Ansprüche, **dadurch gekennzeichnet, dass** das Photovoltaikmodul ein für die Alarmanlage auslesbares elektrisches, insbesondere elektronisches, Bauelement umfasst.

5. Alarmsystem für Photovoltaikmodule nach dem vorstehenden Anspruch, **dadurch gekennzeichnet, dass** das elektrische Bauelement in das Photovoltaikmodul einlaminiert ist.

6. Alarmsystem für Photovoltaikmodule nach einem der vorstehenden Ansprüche, **dadurch gekennzeichnet, dass** das Alarmsystem eine Mehrzahl von Photovoltaikmodulen umfasst, wobei jedem Modul eine eindeutige Kennung zugeordnet ist.

7. Alarmsystem für Photovoltaikmodule nach einem der vorstehenden Ansprüche, **dadurch gekennzeichnet, dass** die Alarmanlage einen Speicher umfasst, in welchem eine Mehrzahl von Photovoltaikmodul-Kennungen speicherbar sind.

8. Alarmsystem für Photovoltaikanlagen nach einem der Ansprüche 1 bis 5, **dadurch gekennzeichnet, dass** die Alarmanlage Mittel aufweist, um die Impulsantwort einer Gruppe aus mehreren Photovoltaikmodulen auszulesen.

9. Alarmsystem für Photovoltaikmodule nach einem der vorstehenden Ansprüche, **dadurch gekennzeichnet, dass** die Alarmanlage an einem Netzeinspeisegerät angeschlossen ist.

10. dass die Alarmanlage in einem Netzeinspeisegerät integriert ist.

11. Alarmsystem für Photovoltaikmodule nach einem der vorstehenden Ansprüche, **dadurch gekennzeichnet, dass** das Alarmsystem eine Mehrzahl von Photovoltaikmodulen und/oder eine Mehrzahl von Photovoltaikmodulgruppen aufweist, die mit einer für die Alarmanlage auslesbaren Kennung versehen sind.

12. Verfahren zum Schutz einer Photovoltaikanlage vor Diebstahl, insbesondere mittels eines Alarmsystems nach einem der vorstehenden Ansprüche, umfassend die Schritte:
- Wiederholtes Auslesen einer Impulsantwort zumindest eines Photovoltaikmoduls;
- Generieren eines Alarmsignals falls die Impulsantwort von einer gespeicherten Impulsantwort abweicht.

13. Verfahren zum Schutz einer Photovoltaikanlage vor Diebstahl nach dem vorstehenden Anspruch, **dadurch gekennzeichnet, dass** das Alarmsystem nachträglich in eine bestehende Photovoltaikanlage eingebaut wird und eine Impulsantwort ausgelesen wird, die zumindest teilweise auf der in dem Photovoltaikmodul integrierten Elektrik oder Elektronik basiert.

14. Verfahren zum Schutz einer Photovoltaikanlage vor Diebstahl nach einem der vorstehenden Ansprüche, **dadurch gekennzeichnet, dass** die Impulsantwort einer Gruppe von Photovoltaikmodulen ausgelesen wird.

15. Verfahren zum Schutz einer Photovoltaikanlage vor Diebstahl nach einem der vorstehenden Ansprüche, **dadurch gekennzeichnet, dass** eine Alarmanlage in einen Programmiermodus versetzt wird, in welchem die Alarmanlage automatisch die Kennung des zumindest einen Photovoltaikmoduls speichert.
